(19) Europäisches Patentamt

European Patent Office

Office européen des brevets

(11) **EP 0 922 936 B1**

(12) **EUROPÄISCHE PATENTSCHRIFT**

(45) Veröffentlichungstag und Bekanntmachung des Hinweises auf die Patenterteilung:
**06.05.2004 Patentblatt 2004/19**

(51) Int Cl.$^7$: **G01D 5/245**, H03M 1/30

(21) Anmeldenummer: **98122422.3**

(22) Anmeldetag: **26.11.1998**

(54) **Wegsensor**

Position sensor

Capteur de position

(84) Benannte Vertragsstaaten:
**DE FR GB**

(30) Priorität: **09.12.1997 DE 19754524**

(43) Veröffentlichungstag der Anmeldung:
**16.06.1999 Patentblatt 1999/24**

(73) Patentinhaber: **Siemens Aktiengesellschaft
80333 München (DE)**

(72) Erfinder: **Gier, Lothar Dr.
61231 Bad Nauheim (DE)**

(56) Entgegenhaltungen:
EP-A- 0 341 882          US-A- 4 757 244
US-A- 4 987 415          US-A- 5 159 192

**Beschreibung**

Die Erfindung betrifft einen Wegsensor zur Erfassung der Stellung zweier relativ zueinander beweglicher Teile, wobei dem ersten Teil wenigstens ein Sensor und dem zweiten Teil in Bewegungsrichtung eine Abfolge von Markierungen zugeordnet ist, die in deckungsgleicher Lage mit einem Sensor diesen auslösen.

Aus der US 4,757,244 ist ein Wegsensor zur Erfassung der Stellung zweier relativ zueinander beweglicher Teile bekannt. Auf einer Stange sind hier magnetische und nicht magnetische Bereiche alternierend angeordnet und eine Vielzahl von Detektorköpfen detektieren den magnetischen Widerstand. Die Detektorköpfe sind entlang der longitudinaler Richtung der Stange angeordnet. Die von den Detektorköpfen erzeugten Signale stehen im direkten Zusammenhang mit der relativen Bewegung der Stange zu den Detektorköpfen.

Wegsensoren werden überall dort benötigt, wo es aus regelungstechnischen Gründen erforderlich ist, die Stellung zweier zueinander beweglicher Teile exakt zu erfassen. Gewöhnlich werden dabei auf einem Maßstab in gleichbleibenden Abständen Markierungen angebracht, die optisch, elektrisch-kapazitiv, magnetisch oder mit einem anderen Verfahren erkannt werden. Beim relativen Verschieben der entsprechenden Sensoren zählen diese die vorbeistreichenden Markierungen. Auf diese Weise erhält man einen inkrementalen Wegsensor, der aber nicht in der Lage ist, die Absolutposition zu bestimmen. Hierzu sind zusätzliche Referenzmarkierungen erforderlich, die als absolute Bezugspunkte erkannt werden können, von denen aus dann relativ die Wegmarkierungen gezählt werden.

Beispielsweise ist es bekannt, eine hydraulische Kolbenstange aus magnetischen Material mit einem Feingewinde zu versehen, das zur Glättung mit einem nicht magnetischen Material gefüllt ist. Die Gänge des Feingewindes bilden dabei die einzelnen Markierungen. Ein magnetischer Sensor, der z. B. magnetoresistiv oder als Hallsensor ausgebildet ist, erfaßt beim Verschieben der Kolbenstange die Anzahl der an ihm vorbeibewegten Gewindegänge, wobei der Verschiebeweg gleich dem Produkt aus der Anzahl der Aktivierungen des Sensors mal der Gewindesteigung ist. Ist eine derartig markierte Kolbenstange in einem ringförmigen Lager geführt, ist es bekannt, auf dessen Umfang mehrere magnetische Sensoren anzuordnen, die beim Verschieben der Kolbenstange mit einer gewissen Phasenverschiebung auf die vorbeilaufenden Gewindegänge reagieren. Durch diese Anordnung ist eine Steigerung der Auflösung des inkrementalen Wegsensors möglich. Die Auflösung entspricht dabei der Steigung des Gewindes dividiert durch die Anzahl der Sensoren auf dem Umfang. Aus der Reihenfolge des Ansprechens der Sensoren läßt sich bei dieser Anordnung auch ein Rückschluß auf die Bewegungsrichtung ziehen.

Bei einem derartigen Wegsensor werden z.B. Markierungen im Gewinde eingebracht, die als Referenzposition erkannt werden können. Jede zusätzliche Referenzmarkierung bedeutet jedoch einen erhebliche erhöhten Aufwand bei der Herstellung und Auswertung des Wegsensors.

Problematisch bei derartigen Lösungen ist, daß nach einem Bewegen der Kolbenstange im ausgeschalteten Zustand des Wegsensors die Absolutposition nach dem Wiedereinschalten zunächst unbekannt ist. Wird ein Wegsensor der zuvor beschriebenen Art beispielsweise in Stoßdämpfer oder Federbeine von Kraftfahrzeugen integriert, um mit Hilfe seiner Messwerte eine Niveauregulierung des Fahrzeuges oder eine Leuchtweitenregulierung zu beeinflussen, besteht das Problem, dass nach dem Beladen eines Fahrzeuges bei ausgeschalteter Spannungsversorgung des Wegsensors beim Starten des Fahrzeuges eine völlig falsche Position angenommen wird und die nach dem falsch angenommenen Absolutwert einregulierten Scheinwerfer andere Verkehrteilnehmer stark blenden. Bei langsamer Fahrt auf ebener Straße und geringer Chassisbewegung ist es möglich, dass zunächst keine Referenzposition überstrichen wird, da sich die Sensoren genau zwischen zwei Referenzmarkierungen befinden. Die falsche Scheinwerfereinstellung bleibt daher bei Weiterfahrt erhalten.

Die Aufgabe der Erfindung besteht darin, einen Wegsensor zu schaffen, der ohne spezielle Referenzmarkierungen in der Lage ist, die Absolutstellung zweier zueinander beweglicher Teile zu bestimmen.

Erfindungsgemäß wird die Aufgabe durch die kennzeichnenden Merkmale des Anspruchs 1 gelöst.

Die Bestimmung des Abstands aus der Phasenverschiebung der z. B. auf einer Ebene quer zur Bewegungsrichtung angeordneten Sensoren lässt bei bekannter Geschwindigkeit die Bestimmung der Absolutposition mit ausreichender Genauigkeit zu, da die Ortsabhängigkeit der Abstände der Markierungen bekannt ist und z. B. eine feste mathematische Beziehung zwischen den Abständen und der Phasenverschiebung der Signale existiert. Damit ist bereits nach dem Überstreichen von wenigstens zwei Markierungen mit bekannter Hubgeschwindigkeit eine definitive Bestimmung der Absolutposition möglich. Durch eine Erhöhung der Anzahl der Sensoren auf dem Kreisumfang lässt sich die Auflösung um einen der Anzahl der Sensoren entsprechenden Faktor erhöhen. Ein Wendel, der je nach Art des Sensors ein Gewindegang, ein Materialauftrag oder lediglich eine optische Markierung sein kann, lässt sich maschinell mit recht einfachen Mitteln erzeugen.

In bevorzugter Weiterbildung der Erfindung ist vorgesehen, dass wenigstens einem der Sensoren ein weiterer, in bestimmtem Abstand in Bewegungsrichtung liegender Sensor zugeordnet ist, wobei der Rechner aus der Zeitverzögerung zwischen diesen beiden Sensorsignalen die momentane Relativgeschwindigkeit der Bewegung errechnet und diese zur Ermittlung des Markierungsabstands bei der Auswertung der Phasenverschiebung der Signale der übrigen Sensoren berücksichtigt.

Damit ist es möglich, die Hubgeschwindigkeit messtechnisch zu erfassen, so dass auch bei nicht bekannter Geschwindigkeit zwischen den beiden Teilen oder bei einer Beschleunigung während der Bewegung eine exakte Auswertung der Absolutposition möglich ist. Je mehr Sensoren über einen ihnen jeweils zugeordneten Sensor in bestimmtem Abstand in Bewegungsrichtung verfügen, desto genauer lassen sich dynamische Bewegungsvorgänge bei der Relativbewegung der beiden Teile kompensieren. Auch bei beliebiger Rotation des Sensorlagers gegen die Kolbenstange steht immer eine Absolutreferenz zur Verfügung.

Die den auf der Querebene angeordneten Sensoren jeweils zugeordneten Markierungen können von einer durchgängigen Markierungslinie mit einer bestimmten Steigung gebildet sein, wobei diese Linie eine Anzahl von Markierungen im Sinne des Anspruchs 1 entsprechend der Anzahl der Sensoren darstellt.

Die Markierungen können beispielsweise auch aus den einzelnen Gängen eines auf einer zylindrischen Fläche des zweiten Teils vorgesehenen Wendels mit variabler Steigung bestehen. Bei einem derartigen Wendel als Markierung sind die Sensoren zweckmäßigerweise auf einem Kreisumfang des ersten Teils in bestimmtem Winkelversatz zueinander angeordnet.

Grundsätzlich eignen sich für den erfindungsgemäßen Wegsensor jegliche Art von Sensoren, wobei bevorzugt optische, elektrischkapazitive oder magnetische Sensoren Verwendung finden, wobei z. B. eine optisch auslesbare Codierung den Vorteil besitzt, dass ein größerer Abstand zwischen Markierung und Detektor möglich ist und damit der Sensor in größerem Abstand reibungs- und verschleißfrei montiert werden kann. Magnetisch mit den Markierungen zusammenwirkende Sensoren verlangen zwar einen geringen Abstand zwischen Sensor und Markierung, sind jedoch beispielsweise sehr unempfindlich gegen Verschmutzungen.

Bei einem erfindungsgemäßen Ausführungsbeispiel ist das zweite Teil zylindrisch, besteht aus magnetischem Material und in seiner Umfangsfläche ist der Wendel in Form eines Gewindes vorgesehen, dessen Gänge mit einem nicht-magnetischen Material gefüllt sind. Das zweite Teil, beispielsweise eine hydraulische Kolbenstange, weist damit im Bereich seiner Oberfläche Zonen unterschiedlicher Permeabilität auf, die von einem magnetoresistiv oder als Hallsensor ausgebildeten Sensor erfaßbar sind.

Da die Oberfläche der Kolbenstange eine Dichtfläche bildet, ist es in diesem Anwendungsfall meist erforderlich, daß die Oberfläche des nicht-magnetischen Materials glatt bündig mit der Umfangsfläche des zweiten Teils abschließt. Die Sensoren können dann beispielsweise auf der Innenumfangsfläche eines Lagerrings angeordnet sein, der das zweite Teil führt. Auf diese Weise kann der Wegsensor in die Stoßdämpfer eines Kraftfahrzeuges integriert werden, um über seine Signale eine Niveauregulierung oder eine Leuchtweitenregulierung des Fahrzeuges zu steuern. Allgemein sind aber auch Wegsensoren denkbar, bei denen das erste Teil einem gefederten und das zweite Teil einem ungefederten Bauteil eines Kraftfahrzeuges oder umgekehrt zugeordnet ist.

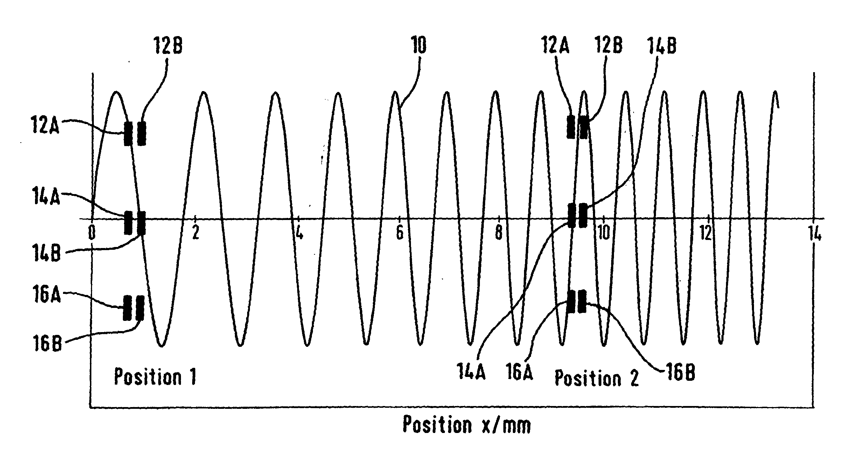

Nachfolgend wird anhand der beigefügten Zeichnung näher auf ein Ausführungsbeispiel der Erfindung eingegangen.

Die Abbildung zeigt schematisch einen Wegsensor. Der Wegsensor besteht im wesentlichen aus einer auf z. B. einer Kolbenstange (nicht gezeigt) aufgebrachten schraubenlinienförmigen Markierung 10, deren Steigung sich über die Länge der Kolbenstange nach einem bestimmten mathematischen Zusammenhang verändert. Beispielsweise kann sich die Steigung der Markierung 10 an einer aktuellen Position X nach dem Zusammenhang $P_x = P_0 \times (1+X/s)$ errechnen, wobei s die gesamte überstrichene Stangenlänge ist. $\sqrt[x]{P_0}$ beträgt dabei beispielsweise 2 mm. Auch andere mathematische Zusammenhänge sind ohne weiteres denkbar.

Zur Erfassung der Markierung sind auf einer zylindrischen Innenumfangsfläche, z. B. der Führungsfläche eines Führungsrings (nicht gezeigt) der Kolbenstange, drei Sensoren 12A, 14A, 16A, in bestimmtem Winkelversatz zueinander vorgesehen. Jedem der Sensoren 12A, 14A, 16A ist ein zweiter, jeweils in einem relativ kleinen axialen Abstand angeordneter weiterer Sensor 12B, 14B, 16B zugeordnet. Der gleichmäßige Winkelversatz zwischen den Sensoren 12A, 14A, 16A beträgt in abgebildeten Ausführungsbeispiel mit drei Sensoren auf dem Umfang 120° und allgemein, bei n Sensoren auf dem Umfang 360°/n zwischen zwei benachbarten Sensoren. Grundsätzlich können aber auch beliebige Winkelabstände zwischen zwei Sensoren vorgesehen sein, solange der Winkelversatz zwischen den einzelnen Sensoren genau bekannt ist und bei der Auswertung der Sensorsignale berücksichtigt werden kann.

Bei einem Hub der Kolbenstange, der z.B. bei Kraftfahrzeug-Stoßdämpfern üblicherweise zwischen 80 mm und 200 mm liegt, sprechen die Sensoren 12A, 14A, 16A mit einer gewissen Phasenverzögerung auf die vorbeilaufende schraubenlinienförmige Markierung 10 an. Auch zwischen dem Ansprechen der mit axialem Abstand angeordneten Sensoren 12A und 12B, 14A und 14B bzw. 16A und 16B, liegt eine zeitliche Verzögerung. Aus diesem Abstand der Signale läßt sich die momentane Hubgeschwindigkeit der Kolbenstange an dieser Position ermitteln. Da die Hubgeschwindigkeit an allen drei Winkelpositionen ermittelt wird, können sich ergebende Veränderungen zwischen den einzelnen Winkelpositionen berücksichtigt und die Hubgeschwindigkeit gegebenenfalls interpoliert werden.

Mit der bekannten Hubgeschwindigkeit kann nun aus dem zeitlichen Versatz der Sensorsignale zweier benachbarter Sensoren unmittelbar die Steigung der Markierung 10 an der Stelle der Sensoren berechnet werden.

Zur Verdeutlichung sind in der Abbildung zwei verschiedene Positionen der Sensoren 12A, B; 14A, B; 16A, B bezüglich der Markierung 10 dargestellt. Während die Steigung im Bereich der Position 1 ungefähr 2 mm beträgt, ist diese im Bereich der Position 2 auf ungefähr 1 mm reduziert. Dies bedeutet, daß bei einer - angenommen - gleichen Hubgeschwindigkeit der zeitliche Versatz zwischen dem Ansprechen der Sensoren in Position 2 in Bezug auf Position 1 halbiert ist. Die Genauigkeit der Sensoren erlaubt es, die Hubgeschwindigkeit derart genau zu ermitteln, daß jeder einzelne Gewindegang mit seiner individuellen Steigung beim Überstreichen exakt ermittelt werden kann.

Bei einmal ermittelter Absolutlage zwischen der Ebene der Sensoren und der Markierung 10 kann im weiteren Verlauf die sich verändernde Absolutlage weiter nach dem vorstehend beschriebenen Ablauf ermittelt werden, es kann jedoch auch ein einfaches Zählen der an den einzelnen Sensoren vorbeistreichenden Gänge der Markierung 10 vorgenommen werden, da der Abstand zweier aufeinander folgender Gänge der Markierung 10 - also die Steigung - bekannt ist.

Ist der zuvor beschriebene Wegsensor beispielsweise in den Stoßdämpfer eines Kraftfahrzeuges integriert, ist bereits nach einem Hub der Kolbenstange von wenigen Millimetern die Möglichkeit zur Errechnung der Absolutposition gegeben.

Die Markierung 10 kann optisch, kapazitiv oder leitfähig codiert sein und mit entsprechenden Sensoren zusammenwirken. Eine magnetische Markierung 10 wird z.B. bei hydraulischen Zylindern bevorzugt, wobei die Markierung 10 aus einem nichtmagnetischen Material besteht, das in einen entsprechend ausgebildeten Gewindegang auf der Kolbenstange eingefüllt ist und bündig mit deren Oberfläche abschließt.

**Patentansprüche**

1. Wegsensor zur Erfassung der Stellung zweier relativ zueinander beweglicher Teile, wobei dem ersten Teil wenigstens zwei Sensoren (12A, 14A, 16A) und dem zweiten Teil in Bewegungsrichtung eine Abfolge von Markierungen zugeordnet ist, die in deckungsgleicher Lage mit einem Sensor diesen auslösen und wobei jede Markierung (10) einen individuellen Abstand zu ihren benachbarten Markierungen in Bezug auf die Bewegungsrichtung besitzt und ein Rechner aus der Phasenverschiebung der Signale der Sensoren (12A, 14A, 16A) errechnet, welchen Abstand die sich im Sensorbereich befindlichen Markierungen (10) besitzen und durch Zuordnung des Abstands die Absolutstellung der beiden Teile zueinander ermittelt, **dadurch gekennzeichnet, dass** die Markierungen von den Schleifen eines auf einer zylindrischen Fläche des zweiten Teils vorgesehen Wendels (10) mit variabler Steigung gebildet sind, wobei die Sensoren (12A, B; 14A B; 16A, B) auf einem Kreisumfang des ersten Teils in bestimmtem Winkelversatz zueinander angeordnet sind.

2. Wegsensor nach Anspruch 1, **dadurch gekennzeichnet, dass** wenigstens einem der Sensoren (12A, 14A, 16A) ein weiterer, in bestimmtem Abstand in Bewegungsrichtung liegender Sensor (12B, 14B, 16B) zugeordnet ist, wobei der Rechner aus der Zeitverzögerung zwischen diesen beiden Sensorsignalen die momentane Relativgeschwindigkeit der Bewegung errechnet und diese zur Ermittlung des Markierungsabstands bei der Auswertung der Phasenverschiebung der Signale der übrigen Sensoren (12A, 14A, 16A) berücksichtigt.

3. Wegsensor nach Anspruch 1 oder 2, **dadurch gekennzeichnet, dass** wenigstens zwei Sensoren (12A, 14A, 16A) auf einer Ebene quer zur Bewegungsrichtung liegen, die jeweils mit Markierungen (10) zusammenwirken.

4. Wegsensor nach einem der Ansprüche 1 bis 3, **dadurch gekennzeichnet, dass** wenigstens jeweils zwei Markierungen von einer Markierungslinie gebildet sind, die eine Steigung besitzt.

5. Wegsensor nach einem der vorhergehenden Ansprüche, **dadurch gekennzeichnet, dass** die Markierungen (10) mit den Sensoren (12A, B; 14A, B; 16A, B) optisch, elektrisch-kapazitiv oder magnetisch zusammenwirken.

6. Wegsensor nach Anspruch 5, **dadurch gekennzeichnet, dass** der Sensor (12A, B; 14A, B; 16A, B) magnetoresistiv oder als Hallsensor ausgebildet ist.

7. Wegsensor nach einem der Ansprüche 5 bis 6, **dadurch gekennzeichnet, dass** das zweite Teil zylindrisch ist, aus magnetischem Material besteht und in seiner Umfangsfläche der Wendel (10) in Form eines Gewindes vorgesehen ist, dessen Gänge mit einem nicht-magnetischen Material gefüllt sind.

8. Wegsensor nach Anspruch 7, **dadurch gekennzeichnet, dass** die Oberfläche des nicht-magnetischen Materials glattbündig mit der Umfangsfläche des zweiten Teils abschließt.

9. Wegsensor nach Anspruch 8, **dadurch gekennzeichnet, dass** die Sensoren (12A, B; 14A, B; 16A, B) auf der Innenumfangsfläche eines Lagerrings angeordnet sind, der das zweite Teil führt.

10. Wegsensor nach einem der vorhergehenden Ansprüche, **dadurch gekennzeichnet, dass** das erste Teil einem gefederten und das zweite Teil einem ungefederten Bauteil eines Kraftfahrzeuges zugeordnet ist.

11. Wegsensor nach Anspruch 10, **dadurch gekennzeichnet, dass** das erste und zweite Teil Bestandteil eines Stoßdämpfers eines Kraftfahrzeuges sind, wobei das zweite Teil die Kolbenstange und das erste Teil dessen Führung bildet.

**Claims**

1. Displacement sensor for acquiring the position of two parts which can be moved relative to one another, the first part being assigned at least one sensor (12A, 14A, 16A) and the second part being assigned, in the direction of movement, a sequence of markings which, when congruent with a sensor, trigger the latter, and each marking (10) having a specific distance from its neighbouring markings with regard to the direction of movement and a computer calculating, from the phase shift of the signals of the sensors (12A, 14A, 16A), the distance of the markings (10) situated in the sensor region and, by assignment of the distance, determining the absolute position of the two parts relative to one another, **characterized in that** the markings are formed by the loops of a helix (10) with a variable pitch, said helix being provided on a cylindrical area of the second part, the sensors (12A, B; 14A, B; 16A; B) being arranged on a circle circumference of the first part with a certain angular offset relative to one another.

2. Displacement sensor according to Claim 1, **characterized in that** at least one of the sensors (12A, 14A, 16A) is assigned a further sensor (12B, 14B, 16B) situated at a certain distance in the direction of movement, the computer calculating, from the time delay between these two sensor signals, the instantaneous relative speed of the movement and taking this into account for the purpose of determining the marking distance during the evaluation of the phase shift of the signals of the remaining sensors (12A, 14A, 16A).

3. Displacement sensor according to Claim 1 or 2, **characterized in that** at least two sensors (12A, 14A, 16A) lie on a plane transversely to the direction of movement which in each case interact with markings (10).

4. Displacement sensor according to one of Claims 1 to 3, **characterized in that** at least two markings in each case are formed by a marking line having a pitch.

5. Displacement sensor according to one of the preceding claims, **characterized in that** the markings (10) interact with the sensors (12A, B; 14A, B; 16A; B) optically, electrically-capacatively or magnetically.

6. Displacement sensor according to Claim 5, **characterized in that** the sensor (12A, B; 14A, B; 16A; B) is of magnetoresistive design or is designed as a Hall sensor.

7. Displacement sensor according to one of Claims 5 to 6, **characterized in that** the second part is cylindrical, is composed of magnetic material and, in its circumferential area, the helix (10) is provided in the form of a thread whose turns are filled with a non-magnetic material.

8. Displacement sensor according to Claim 7, **characterized in that** the surface of the non-magnetic material terminates smoothly flush with the circumferential area of the second part.

9. Displacement sensor according to Claim 8, **characterized in that** the sensors (12A, B; 14A, B; 16A; B) are arranged on the inner circumferential area of a bearing ring which guides the second part.

10. Displacement sensor according to one of the preceding claims, **characterized in that** the first part is assigned to a sprung component of a motor vehicle and the second part is assigned to an unsprung component of a motor vehicle.

11. Displacement sensor according to Claim 10, **characterized in that** the first and second parts are component parts of a shock absorber of a motor vehicle, the second part forming the piston rod and the first part forming its guide.

**Revendications**

1. Capteur de position pour la détection de la position de deux pièces relativement mobiles l'une par rapport à l'autre, aux moins deux capteurs (12A, 14A, 16A) étant associés à la première pièce et une série de marquages qui déclenchent un capteur, lorsque leur position coïncide avec celle de ce dernier, étant associée à la seconde pièce, dans le sens de déplacement et chaque marquage (10) disposant d'une distance individuelle par rapport à son marquage voisin, en référence au sens de déplacement et un ordinateur calculant à partir du déphasage des signaux des capteurs (12A, 14A, 16A) à quelle distance sont placés les marquages (10) situés dans la zone du capteur et déterminant la position absolue des deux pièces l'une par rapport à l'autre, par association de la distance, **caractérisé en ce que** les marquages sont formés par les spires d'une hélice à pas variable (10), prévue sur une surface cylindrique de la seconde pièce, les capteurs (12A, B ; 14A B ; 16A, B) étant disposés sur une périphérie circulaire de la première pièce en présentant un certain déport angulaire, l'un par rapport à l'autre.

2. Capteur de position selon la revendication 1, **caractérisé en ce qu'**un capteur supplémentaire (12B, 14B, 16B), disposé à une distance définie dans le sens de déplacement est associé à au moins l'un des capteurs (12A, 14A, 16A), l'ordinateur calculant la vitesse relative momentanée du déplacement à partir de la temporisation entre les deux signaux des capteurs et les prenant en compte pour déterminer la distance entre les marquages, lors de l'évaluation du déphasage des signaux des capteurs restants (12A, 14A, 16A).

3. Capteur de position selon l'une quelconque des revendications 1 ou 2, **caractérisé en ce qu'**au moins deux capteurs (12A, 14A, 16A) coopérant respectivement avec des marquages (10) sont disposés sur un plan, transversalement au sens de déplacement.

4. Capteur de position selon l'une quelconque des revendications 1 à 3, **caractérisé en ce qu'**au moins respectivement deux marquages sont formés par une ligne de marquage, munie d'un pas.

5. Capteur de position selon l'une quelconque des revendications précédentes, **caractérisé en ce que** les marquages (10) coopèrent par voie optique, électro-capacitive ou magnétique avec les capteurs (12A, B ; 14A, B ; 16A, B).

6. Capteur de position selon la revendication 5, **caractérisé en ce que** le capteur (12A, B ; 14A, B ; 16A, B) est un capteur magnéto-résistif ou conçu sous forme de capteur de Hall.

7. Capteur de position selon l'une quelconque des revendications 5 ou 6, **caractérisé en ce que** la seconde pièce est cylindrique, conçue dans une matière magnétique et **en ce que** l'hélice (10) est prévue sur sa surface périphérique, sous forme d'un filetage, dont les filets sont remplis avec de la matière non magnétique.

8. Capteur de position selon la revendication 7, **caractérisé en ce que** la surface de la matière non magnétique se termine à ras de la surface périphérique de la seconde pièce et de façon lisse.

9. Capteur de position selon la revendication 8, **caractérisé en ce que** les capteurs (12A, B ; 14A, B ; 16A, B) sont disposés sur la surface périphérique interne d'une bague de palier, qui guide la seconde pièce.

10. Capteur de position selon l'une quelconque des revendications précédentes, **caractérisé en ce que** la première pièce est associée à un élément du véhicule qui est sur ressort et la seconde pièce est associée à un élément du véhicule qui n'est pas sur ressort.

11. Capteur de position selon la revendication 10, **caractérisé en ce que** la première et la seconde pièce sont des parties intégrantes d'un amortisseur d'un véhicule, la seconde pièce formant la tige de piston et la première pièce formant le système de guidage de cette dernière.

12B                                    10        12A 12B  14B

12A

14A

14B

16A

16B

Position 1                    14A  16A  Position 2      16B

Position x/mm

EP 0 922 936 B1